# EUROPEAN PATENT SPECIFICATION

(11) **EP 1 744 326 B1**
(45) Date of publication and mention of the grant of the patent: **30.09.2009**
(21) Application number: 06405255.8
(22) Date of filing: 13.06.2006
(51) Int. Cl.: H01B 1/00

(54) **Conductive filler and use thereof**
Leitfähiger Füllstoff und Verwendung desselben
Charges conductrices et son utilisation

(30) Priority: 12.07.2005 EP 05405434
(43) Date of publication of application: 17.01.2007
(73) Proprietor: Sulzer Metco (Canada) Inc., Fort Saskatchewan, Alberta T8L 4R1 (CA)
(72) Inventor: Callen, Brian William, Sherwood Park Alberta T8H 2P4 (CA); Walkhouse, William Kimber, Gibbons Alberta T0A 1N0 (CA)
(74) Representative: Sulzer Management AG

(56) References cited:
- WO-A-94/11885
- US-A- 5 498 372
- US-A- 5 910 524
- US-A- 5 958 302
- US-A- 6 132 645
- US-A1- 2002 160 193

## Description

### Field of the Invention

The present invention relates to a particulate conductive filler for EMI shielding applications according to the preamble of claim 1 and to a conductive polymer composition comprising such a conductive filler. The invention further relates to a method of providing EMI shielding according to the preamble of claim 9.

### Description of the Related Art

Conventional shielding products are used in electronic applications ranging from aerospace components to cellular telephones to provide protection from electromagnetic interference (EMI) and radio frequency interference (RFI). Typically, such shielding products were formed by the introduction of a conductive filler into a polymeric matrix based on the premise that reduced volume resistance (DC resistance) translates to an increase in shielding effectiveness. The trade journal article Interference Technology Engineers' Master ITEM 1999 "Correlating DC Resistance to the Shielding Effectiveness of an EMI Gasket" Thomas Clupper p. 59 produces theoretical models that relate shielding effectiveness to resistance. The EMI shielding effectiveness of two gasket materials and DC resistance across each gasket were measured while each gasket was mounted in a fixture. A resistance of 1 ohm was measured across the fixture for gasket A and 0.01 ohm was measured for gasket B. The EMI shielding effectiveness of gaskets A and B were measured at 65 dB and 42 dB respectively at 100 MHz, showing an increase in shielding effectiveness with reduced volume resistivity.

Initially, the conductive fillers were composed of solid noble metal particles. However, such fillers are extremely costly and attempts were made to develop more economic conductive fillers without the loss of shielding and conductivity properties. Less costly alternative materials consist of noble metals clad on comparatively inexpensive core materials such as glass, aluminum or copper. The use of noble metals is considered too costly for some applications. Subsequently, copper and nickel powders were used for this purpose, followed by the use of nickel clad graphite or carbon core particles.

In U.S. Patent 5,284,888, there is disclosed an EMI/RFI shielding composition which comprises a polyurethane resin formed of two polymers having a stabilized conductive filler therein and an azole. The preferred filler is a silver stabilized copper powder.

Kalinoski et al. U.S. Patent 6,096,413 describes a conductive gasket produced through a form-in-place process involving silicone, urethane and/or thermoplastic block copolymers having a conductive filler associated therewith. The conductive fillers used to fill the elastomers can be selected from pure silver, noble metal-plated non-noble metals such as silver plated copper, nickel or aluminum. Non-noble metal-based materials including non-noble metal-plated non-noble metals are also suitable, exemplary of which would be copper-coated iron particles. In addition, non-metal materials such as carbon black and graphite and combinations thereof, may be used.

An EMI shielding gasket using a conductive filler of nickel coated graphite particles having a size of 75 microns, with EMI shielding effectiveness of at least 80 dB between 10 MHz and 10 GHz, is described by Kalinoski in U.S. Patent 5,910,524 entitled "Corrosion-resistant form-in-place EMI shielding gasket". The volume resistivity of this material is reported to be from about 500 to 1000 milliohm-cm.

WO 94/11885 A, US 6,132,645 and US 5,498,372 describe electrically conductive polymer compositions including conductive polymer coated carbon particles embedded in a matrix polymer.

US 5,958,302 describes the preparation of small conductive submicron polymeric composites comprised of a polymer matrix and a conductive filler polymer distributed uniformly in the polymer matrix of the composite.

US 2002/160 193 A1 describes a particulate conductive filler comprised of a noble-metal plated coating on an intermediate non-noble metal plated coating over a carbon-based core. The carbon-based cores have an average size of about 1 to 300 microns.

### SUMMARY OF THE INVENTION

The invention provides a particulate conductive filler for EMI shielding applications having the features of claim 1 and a conductive polymer composition comprising the particulate conductive filler and having the features of claim 5. The invention further provides a method of providing EMI shielding having the features of claim 9. Preferred embodiments are described in dependent claims.

It is a principal object of the present invention to provide a particulate conductive filler comprised of a conductive metal coating over a carbon core with a coarse particle size of 350 to 1000 microns. The particulate conductive filler is combined with a polymer matrix to produce conductive composite materials with enhanced physical and electrical properties from which desired components may be manufactured.

The essential feature of this invention thus is to coat nickel or another conductive metallic material onto carbon particles such as graphite having an average size in the range of 350 to 1000 microns. The metal coated graphite is then incorporated into an elastomer matrix, such as silicone, rendering it conductive. The filled elastomer is formed into various types of EMI shielding gaskets for applications such as door and panel seals. Surprising enhancements in utility result from the use of metal coated carbon particles that are significantly larger in size than that used in prior art. The inventive advantages of using large metal coated carbon particles as a filler include improved process rheology, greater flexibility in filler loading, improved electrical conductivity and improved electrical stability and lower density compared to current fillers of similar composition that have smaller particle size.

In its broad aspect, there is provided a particulate conductive filler comprised of coated particles for use with a polymer matrix to form conductive polymer compositions wherein each coated particle comprises a central carbon-based core having an average size in the range of 350 to 1000 microns, and a conductive metal coating on said central carbon-based core. The central carbon-based core is selected from the group consisting of natural graphite, synthetic graphite, carbon black and mixtures thereof and has an average size in the range of about 350 to 1000 microns, preferably 400 to 800 microns, and more preferably about 600 microns. The conductive metal is one or more metals selected from the group consisting of nickel, copper, aluminum, tin, cobalt, zinc, gold, silver, platinum, palladium, rhodium, iridium, indium and their alloys, and comprises about 20 to 90 weight % of the coated particles, preferably about 40 to 90 weight %. Noble metals gold, silver, platinum, palladium, rhodium, iridium and their alloys may be used alone or may coat one or more of the non-noble metals nickel, copper, aluminum, tin, cobalt, zinc, indium and their alloys. The particulate conductive filler preferably is a central carbon-based core of natural graphite or synthetic graphite with a conductive metal coating of nickel, the nickel comprising about 40 to 80 weight % of the coated particles and encapsulating the carbon-based core. Gold or silver comprising about 1 to 40 weight % of the coated particle may encapsulate the nickel.

The invention further extends to a composite material comprising a polymer matrix having uniformly dispersed therein the filler of particles formed of the carbon core having a conductive metal coating thereon, the particulate filler typically having a filler loading of about 25 to 35 volume %. The polymer matrix may be selected from any single or combination of natural rubbers and synthetic elastomers including hydrocarbon rubbers (EPM, EPDM, butyl and the like), nitriles, polychloroprenes, acrylic, fluoro- and chlorosulfonated polyethylenes, polyurethanes, polyethers, polysulfides, nitrosorubbers, silicones and fluorosilicones. Preferably, said elastomer polymer matrix is silicone elastomer and said particulate filler is graphite powder coated with nickel. More preferably, the graphite powder has an average size of about 600 microns, the nickel comprises up to about 60 weight % of the coated particles, and the coated particles comprise about 30% volume of the composite material.

In a further embodiment, the conductive polymer composition additionally comprises about 1 to 30 weight % particulate conductive fillers typified by silver coated glass spheres having a size in the range of 20 to 200 microns.

In a still further embodiment, a noble metal typified by gold or silver in the amount of about 1 to 40% weight of the coated particle may coat a non-noble metal such as nickel.

The method of the invention for providing EMI shielding for application to a substrate comprises the steps of forming a composite of a polymer matrix and a particulate conductive filler uniformly dispersed in the polymer matrix, said particulate filler comprising a central carbon-based core having an average size in the range of about 350 to 1000 microns, preferably about 400 to 800 microns, selected from the group consisting of natural graphite, synthetic graphite, carbon black and mixtures thereof and a conductive metal coating of one or more metals selected from the group consisting of nickel, copper, aluminum, tin, cobalt, zinc, gold, silver, platinum, palladium, rhodium, iridium, indium and their alloys encapsulating said central carbon-based core. The conductive metal, composite metals or alloys thereof comprise about 20 to 90 weight % of the coated particles, preferably about 40 to 90 weight % of the coated particles.

The conductive metal preferably is nickel and the central carbon-based core preferably is natural graphite or synthetic graphite having an average particle size of about 600 microns, said nickel comprising about 40 to 80 weight %, preferably about 60 weight % , of the coated particles. A noble metal such as gold or silver forming a coating on a non-noble metal coating such as nickel encapsulating the central carbon-based core may comprise 1 to 40 weight % of the coated particle.

The particulate filler may additionally comprise about 1 to 30 weight % particulate conductive fillers typified by silver coated glass spheres having a size in the range of 20 to 200 microns.

Advantageously, as a result of practicing this invention, such as by providing a metal or composite metal coating on a graphite core of average particle size of 350 -1000 microns, there is provided:
- A conductive filler that has improved processing rheology.
- A conductive filler that has a wider range of loading levels to attain electrical and mechanical performance.
- A conductive filler that uses less metal
- A conductive filler that has a lower density.
- A conductive filler that is lower cost.
- A conductive elastomer that has improved electrical conductivity.
- A conductive elastomer that has improved electrical stability.
- A conductive elastomer that can be fabricated by methods well known in the art.

### DESCRIPTION OF THE DRAWINGS

The particulate composite filler, conductive polymer composition and method of providing EMI shielding, of the invention, will be better understood from the following description taken in conjunction with the accompanying drawings, in which:
- Figure 1: is a cross-sectional view of the nickel coated graphite particles of the prior art loaded into a polymer matrix; and
- Figure 2: is a cross-sectional view of an embodiment of conductive filler particles of the present invention loaded into a polymer matrix.

### DESCRIPTION OF THE PREFERED EMBODIMENT

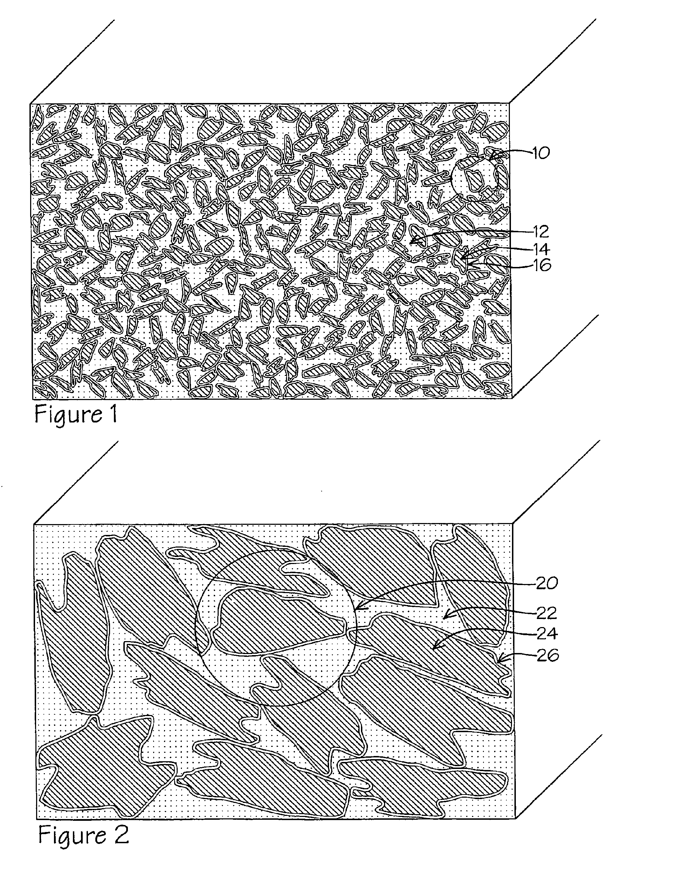

Having reference to the accompanying drawings, there is shown in Figure 1 an example of prior art nickel coated graphite particles 10 used as the filler in a polymer matrix 12. The conductive particles comprise an inner graphite core 14 with a nickel metal coating 16 thereon.

Figure 2 depicts the conductive filler particles 20 of the present invention in a polymer matrix 22 wherein the graphite-based core 24 has a metal coating 26. The particles depicted in Figure 2, which illustrate an example of 600 micron sized particles of the invention, are two-hundred-and-sixteen times larger in volume than 100 micron sized particles of prior art depicted in Figure 1.

In the embodiment illustrated in Figure 2, the inner core is graphite. The nickel coating 26 is applied to the core 24 using conventional techniques well-known in the art such as electroless plating, carbonyl process or hydrometallurgy, preferably to provide continuous encapsulation of the core. The metal coating such as nickel or silver is functional to provide bulk conductivity from particle to particle. Although it is preferred to completely encapsulate the core with the metal, it will be understood that desired conductivity or EMI shielding effectiveness may be attained with partial cladding of the core by the metal.

The inner core 24 may be formed of any suitable natural or synthetic graphite having an average size in the range of about 350 to 1000 microns, preferably about 400 to 800 microns, and more preferably about 600 microns in size.

The metal coating 26 may be selected from nickel, copper, aluminum, tin, cobalt, zinc, gold, silver, platinum, palladium, rhodium, iridium, indium or their alloys and encapsulates the core in an amount which is necessary to provide conductivity in the composition. A metal coating or composite metal coating in the amount of about 20 to 90 wt% of the coated particle, preferably about 40 to 90 wt%, has been found suitable to provide desired conductivity. The coating may be a single coating of a non-noble or noble metal or may be a composite coating, preferably of a noble metal on a non-noble metal such as gold or silver on nickel. The polymer matrix includes natural and synthetic elastomers, namely natural rubber and synthetic elastomers including hydrocarbon rubbers (EPM, EPDM, butyl and the like), nitriles, polychloroprenes, acrylic, fluoro- and chlorosulfonated polyethylenes, polyurethanes, polyethers, polysulfides, nitrosorubbers, silicones and fluorosilicones and acrylics and mixtures thereof.

The particulate conductive filler of the invention is present in an amount up to 80 wt%, preferably about 50 to 70 wt%, of the composite material, depending on the conductive filler particle density and polymer matrix density. For example, particles containing 20% nickel by weight would comprise up to about 35-45wt% of the composite materials and particles containing 80% nickel by weight would comprise up to about 70-80 wt% of the composite materials (assuming polymer density of~1 g/cm³).

The particulate conductive material may be mixed with other particulate conductive fillers in the amount of 1 to 30 weight % such as typified by silver-coated glass spheres in the size range of 20 to 200 microns to impart improved flow characteristics to the polymer matrix.

Conventional conductive fillers for EMI shielding and other conductive applications use particles that are smaller than 250 microns. Some applications (such as those produced by the form-in-place process) require the conductive fillers to have small particles sizes because the gasket is very thin (less than 1 mm) or have a small cross sectional area. Such gaskets require the filler to have the particle size less than 100 microns in size. Other applications, such as door and panel seals on enclosures do not have such an inherent limitation on particle size. Such relatively thick gasket applications need not be limited to using the conductive fillers of prior art, which usually are less than 150 microns in size.

The mechanical process of loading polymers with conductive fillers requires sufficient loading levels to be achieved in order to produce specified conductivity performance. The loading levels are typically at or greater than the electrical percolation threshold, typically in the range of 25-35% filler loading by volume. The high loading levels often cause difficulties in mechanical processing such as compounding, molding and extrusion where too much filler does not allow the material to flow sufficiently. Such rheological problems are often solved by using less filler, which had a cost of decreasing conductivity. Once fabricated, the polymeric conductive gasket has prespecified mechanical properties of hardness and strength. Gaskets produced from polymeric elastomers are desired to be soft and strong to form tight and durable seals that are also sufficiently conductive. The common challenge is using sufficient filler to provide the necessary electrical properties without overly compromising the mechanical properties imparted by the elastomer. Coarse particles loaded into polymer resins have smaller total particle surface areas to be wetted by the polymer compared to smaller particles of the same composition. Thus, coarser particles provide improved flowability, or rheology during processing compared to finer particles. The improved flowability imparted by the coarse particles produces improved flexibility in adjusting the filler loading to optimize the electrical and mechanical properties of the cured gasket material. There is an additional inherent advantage of coarse particles having a smaller surface area per unit volume compared to finer particles: A smaller total mass of metal coating produces the same metal coating thickness on the coarse particles because of the lower surface area. The small amount of metal translates to the advantages of a lower density material, and a potential cost savings on the filler by using less metal. The property of decreasing the amount of metal does not decrease performance because the metal coating thickness has not changed.

The coarse particles also provide enhanced conductivity at equal volume loading in the elastomer compared to finer particles of the same composition. Fewer coarse particles occupy the same volume as finer particles (at equal volume loading) within the elastomer, resulting in fewer surface-to-surface electrical contact points. The conductivity of the particle-filled polymer is largely determined by particle-to-particle contact resistance, and a smaller number of particles per unit volume will produce fewer electrical contact points across a fixed distance in the elastomer. The coarse powder will have fewer resistance points in a series-circuit compared to a finer powder at the same loading level and would result in improved conductivity across the gasket. Improved electrical resistance to heat aging was an unexpected enhancement observed for silicone loaded with a coarse nickel-coated graphite filler compared to a finer nickel graphite filler at the same volume loading level. This surprising observation is not clearly understood, but may be related to the coarse powder having lower number of electrical contact points to be degraded by the effects of heat aging.

The particulate conductive filler and the composite material of the invention will now be described with reference to the following non-limitative examples.

### EXAMPLES

### Example 1

Graphite powder of average particle size of 611 microns was clad by hydrometallurgy with nickel to produce a conductive powder 53% by weight nickel and 47 % by weight graphite (true particle density 3.7 g/cm³). As a comparison, conventional nickel coated graphite powder (Ni/Graphite) of composition 63.5% by weight Ni and 36.5% by weight graphite (true particle density 4.2 g/cm³) with an average particle size of 120 microns was used as baseline conductive powder filler. Conductive silicone rubber sheets were prepared as follows. Each powder sample was compounded with a heat curable silicone resin on a two-roll mill to 60 % weight powder loading for the 611 micron powder and 63.5% by weight for the 120 micron powder. The different weight loading used for the two powders was to correct for differences in true particle density in order to prepare samples with an equal filler volume loading of about 31 %.

The 120 micron nickel graphite powder required 35 minutes to fully incorporate the filler into the resin to form a uniform and well blended composition. In contrast, the 611 micron nickel graphite powder only required 15 minutes to achieve the same uniformity and well blended composition with the same operator and compounding procedure. In addition to observing a faster compounding time for the coarser filler, the compound material produced had a greater affinity to accept additional filler.

### Example 2

The silicone resin compound materials containing 120 micron particles and 611 micron particles as prepared in Example 1 were cured and molded in a hot press to form square conductive silicone rubber sheets 15 cm wide and 1.8 mm thick. The volume resistivities of the conductive cured sheets were measured on 1 cm diameter discs cut from the sheets through two electrodes connected to a 4-point resistance probe (Keithely™ model 580 micro-ohmmeter). The calculation of volume resistivity accounted for the volume of rubber between the two electrodes that was pressed on the opposite ends of each conductive silicone rubber disc.

The volume resistivity measured by this method was 25 mΩ·cm and 17 mΩ·cm for the 120 micron and 611 micron nickel graphite powders, respectively. This represents a 32% decrease in volume resistivity for the coarse powder compared to the finer powder as loaded in silicone rubber. The Shore A hardness of the disks was measured to be 79 and 77 for the120 micron and 611 micron nickel graphite powders, respectively.

The discs prepared in Example 2 were placed into an air circulating oven set at 150 C for 48 hours. The disks were then remeasured for volume resistivity as reported in Table 1:

**Table 1: Volume resistivity and Shore A hardness for silicone rubber loaded with nickel graphite powders:**

| Nickel graphite type | Volume resistivity prior to aging | Volume resistivity following aging | Volume resistivity ratio | Shore A hardness |
|---|---|---|---|---|
| 120 micron | 25 | 56 | 2.3 | 79 |
| 611 micron | 17 | 28 | 1.6 | 77 |

The sample with the 120 micron powder increased in volume resistivity by a factor of 2.3 (or 124% increase), while sample with the coarser sample only increased by a factor of 1.6 (or 64% increase).

## Claims

1. A particulate conductive filler for EMI shielding applications comprised of coated particles for use with a polymer matrix to form conductive polymer compositions wherein each coated particle comprises a central carbon-based core selected from the group consisting of natural graphite, synthetic graphite, carbon black and mixtures thereof, and a conductive metal coating or composite metal coating on said central carbon-based core,
**characterized in that**
the carbon-based core has an average size in the range of 350 to 1000 microns, in particular 400 to 800 microns.

2. The particulate filler according to claim 1 wherein said conductive metal coating is comprised of one or more metals selected from the group consisting of nickel, copper, aluminum, tin, cobalt, zinc, gold, silver, platinum, palladium, rhodium, indium, iridium and their alloys and the composite metal coating is comprised of a non-noble metal coating selected from the group consisting of nickel, copper, aluminum, tin, cobalt, indium and zinc coating the carbon-based core and a noble metal selected from the group consisting of gold, silver, platinum, palladium, rhodium and iridium encapsulating the non-noble mental coating and / or the conductive metal or alloy thereof comprises 20 to 90 weight % of the coated particles, in particular about 40 to 90 weight %.

3. The particulate conductive filler according to claim 1 or 2 wherein said conductive metal coating is nickel and said central carbon-based core is natural graphite or synthetic graphite, preferably, the nickel is 40 to 80 weight % of the coated particles and encapsulates the carbon-based core.

4. The particulate conductive filler as claimed in one of the preceding claims wherein said composite metal coating comprises nickel coating the carbon-based core and gold or silver encapsulating the nickel coating.

5. A conductive polymer composition comprising a polymer matrix and a particulate conductive filler according to one of claims 1 to 4 therein,
**characterized in that**
the particulate conductive filler comprising 25 to 35 volume % of the conductive polymer composition.

6. The conductive polymer composition as claimed in claim 5 wherein the polymer matrix is selected from the group consisting of hydrocarbon rubbers (EPM, EPDM. butyl and the like), nitriles, polychloroprenes, acrylic, fluoro- and chlorosulfonated polyethylenes, polyurethanes, polyethers, polysulfides, nitrosorubbers, silicones and fluorosilicones, and / or said conductive metal is one or more metals selected from the group consisting of nickel, copper, aluminum, tin, cobalt, zinc, gold, silver, platinum, palladium, rhodium, iridium, indium and their alloys, and / or the conductive metal or alloy thereof, preferably, comprises 20 to 90 weight % of the coated particles, in particular 40 to 90 weight %.

7. The conductive polymer composition as claimed in claim 5 or 6, wherein the conductive metal coating is nickel and said central carbon-based core is natural or synthetic graphite powder, said nickel coating encapsulating the natural or synthetic graphite, and/or said polymer matrix is, preferably, silicone polymer and/or, preferably, the nickel comprises 40 to 80 weight % of the coated particles and encapsulates the carbon-based core, said particulate filler comprising about 30 volume % of the conductive polymer composition.

8. The conductive polymer composition as claimed in any one of claims 5 to 7 wherein the composite metal coating is comprised of a non-noble metal coating selected from the group consisting of nickel, copper, aluminum, tin, cobalt, indium and zinc coating the carbon-based core and a noble metal selected from the group consisting of gold, silver, platinum, palladium, rhodium and iridium encapsulating the non-noble metal coating, and / or the graphite powder, preferably, has an average size of about 600 microns and the nickel comprises about 60 weight % of the coated particles and / or additionally preferably comprising 1 to 30 weight % particulate conductive fillers typified by silver coated glass spheres having a size in the range of 20 to 200 microns.

9. A method of providing EMI shielding for application to a substrate comprising the steps of forming a composite material of a polymer matrix and a particulate conductive filler uniformly dispersed in the polymer matrix, said particulate filler comprising a central carbon-based core selected from the group consisting of natural graphite, synthetic graphite, carbon black and mixtures thereof, and a conductive metal coating or composite metal coating encapsulating said central carbon-based core,
**characterized in that**
the composite material comprises 25 to 35 volume % of the particulate conductive filler, said polymer matrix selected from the group consisting of hydrocarbon rubbers (EPM, EPDM, butyl and the like), nitriles, polychloroprenes, acrylic, fluoro- and chlorosulfonated polyethylenes, polyurethanes, polyethers, polysulfides, nitrosorubbers, silicones and fluorosilicones, said conductive metal coating or composite metal coating comprising one or more metals selected from the group consisting of nickel, copper, aluminum, tin, cobalt, zinc, gold, silver, platinum, palladium, rhodium, iridium, indium and their alloys, and the carbon-based core having an average size in the range of 350 to 1000 microns, in particular 400 to 800 microns.

10. A method as claimed in claim 9 wherein the metal coating, composite metal coating or alloy thereof comprises 20 to 90 weight % of the coated particles, preferably about 40 to 90 weight % of the coated particles and / or, preferably, the conductive metal is nickel and the central carbon-based core is natural graphite or synthetic graphite having an average particle size of about 600 microns, said nickel consisting of about 60 weight % of the coated particles, and the conductive filler comprises about 30 volume % of the composite material, and / or, preferably, the composite metal coating comprises a non-noble metal selected from the group consisting of nickel, copper, aluminum, tin, cobalt, indium and zinc, preferably nickel, coating the carbon-based core, and a noble metal selected from the group consisting of gold, silver, platinum, palladium, rhodium, iridium and their alloys, preferably gold, or silver encapsulating the non-noble metal coating and / or, preferably, the polymer is silicone and the composite metal coating comprises nickel coating the carbon-based core, and gold or silver encapsulating the nickel coating and / or, preferably, the particulate filler additionally comprises 1 to 30 weight % particulate conductive fillers typified by silver coated glass spheres having a size in the range of 20 to 200 microns.

## Patentansprüche

1. Partikulärer leitender Füllstoff für EMI-Abschirmanwendungen, bestehend aus beschichteten Partikeln zur Verwendung mit einer Polymermatrix, um leitende Polymerzusammensetzungen zu bilden, wobei jedes beschichtete Partikel einen zentralen Kern auf Kohlenstoffbasis, der aus der Gruppe gewählt ist, die aus natürlichem Graphit, synthetischem Graphit, Ruß bzw. Carbon-Black und Mischungen davon besteht, und eine leitende Metallbeschichtung oder Verbundmetallbeschichtung an dem zentralen Kern auf Kohlenstoffbasis umfasst,
**dadurch gekennzeichnet, dass**
der Kern auf Kohlenstoffbasis eine durchschnittliche Größe im Bereich von 350 bis 1000 Mikrometer, insbesondere 400 bis 800 Mikrometer besitzt.

2. Partikulärer Füllstoff nach Anspruch 1, wobei die leitende Metallbeschichtung aus einem oder mehreren Metallen besteht, die aus der Gruppe gewählt sind, die aus Nickel, Kupfer, Aluminium, Zinn, Kobalt, Zink, Gold, Silber, Platin, Palladium, Rhodium, Indium, Iridium und deren Legierungen besteht, und die Verbundmetallbeschichtung aus einer Nichtedelmetallbeschichtung, die aus der Gruppe gewählt ist, die aus Nickel, Kupfer, Aluminium, Zinn, Kobalt, Indium und Zink besteht und den Kern auf Kohlenstoffbasis beschichtet, und einem Edelmetall besteht, das aus der Gruppe gewählt ist, die aus Gold, Silber, Platin, Palladium, Rhodium und Iridium besteht und die Nichtedelmetallbeschichtung einkapselt, und/oder das leitende Metall oder die leitende Legierung davon 20 bis 90 Gew.-% der beschichteten Partikel, insbesondere etwa 40 bis 90 Gew.-% umfasst.

3. Partikulärer leitender Füllstoff nach einem der Ansprüche 1 oder 2, wobei die leitende Metallbeschichtung Nickel ist und der zentrale Kern auf Kohlenstoffbasis natürliches Graphit oder synthetisches Graphit ist, wobei das Nickel bevorzugt 40 bis 80 Gew.-% der beschichteten Partikel ausmacht und den Kern auf Kohlenstoffbasis einkapselt.

4. Partikulärer leitender Füllstoff nach einem der vorhergehenden Ansprüche, wobei die Verbundmetallbeschichtung Nickel, das den Kern auf Kohlenstoffbasis beschichtet, und Gold oder Silber umfasst, das die Nickelbeschichtung einkapselt.

5. Leitende Polymerzusammensetzung, umfassend eine Polymermatrix und einen partikulären leitenden Füllstoff nach einem der Ansprüche 1 bis 4 darin,
**dadurch gekennzeichnet, dass**
der partikuläre leitende Füllstoff 25 bis 35 Vol.-% der leitenden Polymerzusammensetzung umfasst.

6. Leitende Polymerzusammensetzung nach Anspruch 5, wobei die Polymermatrix aus der Gruppe gewählt ist, die aus Kohlenwasserstoffkautschuk (EPM, EPDM, Butyl und dergleichen), Nitrilen, Polychloroprenen, Acrylharzen, fluor- und chlorsulfonierten Polyethylenen, Polyurethanen, Polyethern, Polysulfiden, Nitrosokautschuk, Silikonen und Fluorsilikonen besteht, und/oder das leitende Metall ein oder mehrere Metalle umfasst, die aus der Gruppe gewählt sind, die aus Nickel, Kupfer, Aluminium, Zinn, Kobalt, Zink, Gold, Silber, Platin, Palladium, Rhodium, Iridium, Indium und deren Legierungen besteht, und/oder das leitende Metall oder die leitende Legierung davon bevorzugt 20 bis 90 Gew.-% der beschichteten Partikel, insbesondere 40 bis 90 Gew.-% umfasst.

7. Leitende Polymerzusammensetzung nach einem der Ansprüche 5 oder 6, wobei die leitende Metallbeschichtung Nickel ist und der zentrale Kern auf Kohlenstoffbasis natürliches oder synthetisches Graphitpulver ist, wobei die Nickelbeschichtung das natürliche oder synthetische Graphit einkapselt, und/oder die Polymermatrix bevorzugt ein Silikonpolymer ist und/oder das Nickel bevorzugt 40 bis 80 Gew.-% der beschichteten Partikel umfasst und den Kern auf Kohlenstoffbasis einkapselt, wobei der partikuläre Füllstoff etwa 30 Vol.-% der leitenden Polymerzusammensetzung umfasst.

8. Leitende Polymerzusammensetzung nach einem der Ansprüche 5 bis 7, wobei die Verbundmetallbeschichtung aus einer Nichtedelmetallbeschichtung, die aus der Gruppe gewählt ist, die aus Nickel, Kupfer, Aluminium, Zinn, Kobalt, Indium und Zink besteht und den Kern auf Kohlenstoffbasis beschichtet, und einem Edelmetall besteht, das aus der Gruppe gewählt ist, die aus Gold, Silber, Platin, Palladium, Rhodium und Iridium besteht und die Nichtedelmetallbeschichtung einkapselt, und/oder das Graphitpulver bevorzugt eine durchschnittliche Größe von etwa 600 Mikrometer besitzt und das Nickel etwa 60 Gew.-% der beschichteten Partikel umfasst, und/oder zusätzlich bevorzugt mit 1 bis 30 Gew.-% partikulären leitenden Füllstoffen, die durch Silber beschichtete Glaskugeln mit einer Größe im Bereich von 20 bis 200 Mikrometer typisiert sind.

9. Verfahren zum Bereitstellen einer EMI-Abschirmung für eine Anwendung auf einem Substrat, mit den Schritten, dass ein Verbundmaterial aus einer Polymermatrix und einem partikulären leitenden Füllstoff, der gleichförmig in der Polymermatrix dispergiert ist, geformt wird, wobei der partikuläre Füllstoff einen zentralen Kern auf Kohlenstoffbasis, der aus der Gruppe gewählt ist, die aus natürlichem Graphit, synthetischem Graphit, Ruß bzw. Carbon-Black und Mischungen davon besteht, und eine leitende Metallbeschichtung oder Verbundmetallbeschichtung, die den zentralen Kern auf Kohlenstoffbasis einkapselt, umfasst,
**dadurch gekennzeichnet, dass**
das Verbundmaterial 25 bis 35 Vol.-% des partikulären leitenden Füllstoffs umfasst, wobei die Polymermatrix aus der Gruppe gewählt ist, die aus Kohlenwasserstoffkautschuk (EPM, EPDM, Butyl und dergleichen), Nitrilen, Polychloroprenen, Acrylharzen, fluor- und chlorsulfonierten Polyethylenen, Polyurethanen, Polyethern, Polysulfiden, Nitrosokautschuk, Silikonen und Fluorsilikonen besteht, wobei die leitende Metallbeschichtung oder Verbundmetallbeschichtung eines oder mehrere Metalle umfasst, die aus der Gruppe gewählt sind, die aus Nickel, Kupfer, Aluminium, Zinn, Kobalt, Zink, Gold, Silber, Platin, Palladium, Rhodium, Iridium, Indium und deren Legierungen besteht, und der Kern auf Kohlenstoffbasis eine durchschnittliche Größe im Bereich von 350 bis 1000 Mikrometer, insbesondere 400 bis 800 Mikrometer besitzt.

10. Verfahren nach Anspruch 9, wobei die Metallbeschichtung, die Verbundmetallbeschichtung oder eine Legierung davon 20 bis 90 Gew.-% der beschichteten Partikel, bevorzugt etwa 40 bis 90 Gew.-% der beschichteten Partikel umfasst, und/oder das leitende Metall bevorzugt Nickel ist und der zentrale Kern auf Kohlenstoffbasis natürliches Graphit oder synthetisches Graphit mit einer durchschnittlichen Partikelgröße von etwa 600 Mikrometer ist, wobei das Nickel aus etwa 60 Gew.-% der beschichteten Partikel besteht und der leitende Füllstoff etwa 30 Vol.-% des Verbundmaterials umfasst, und/oder die Verbundmetallbeschichtung bevorzugt ein Nichtedelmetall, das aus der Gruppe gewählt ist, die aus Nickel, Kupfer, Aluminium, Zinn, Kobalt, Indium und Zink, bevorzugt Nickel besteht und den Kern auf Kohlenstoffbasis beschichtet, und ein Edelmetall umfasst, das aus der Gruppe gewählt ist, die aus Gold, Silber, Platin, Palladium, Rhodium, Iridium und deren Legierungen, bevorzugt Gold oder Silber besteht und die Nichtedelmetallbeschichtung einkapselt, und/ oder das Polymer bevorzugt Silikon ist und die Verbundmetallbeschichtung Nickel, das den Kern auf Kohlenstoffbasis beschichtet, und Gold oder Silber umfasst, das die Nickelbeschichtung einkapselt und/oder der partikuläre Füllstoff bevorzugt zusätzlich 1 bis 30 Gew.-% partikuläre leitende Füllstoffe umfasst, die durch Silber beschichtete Glaskugeln mit einer Größe im Bereich von 20 bis 200 Mikrometer typisiert sind.

## Revendications

1. Charge conductrice particulaire pour des applications de bouclier électromagnétique, composée de particules revêtues pour une utilisation avec une matrice polymère afin de former des compositions polymères conductrices dans laquelle chaque particule revêtue comprend un noyau central à base de carbone choisi dans le groupe constitué par le graphite naturel, le graphite synthétique, le noir de carbone et leurs mélanges, et un revêtement métallique conducteur ou un revêtement métallique composite sur ledit noyau central à base de carbone,
**caractérisée en ce que**
le noyau à base de carbone présente une taille moyenne de l'ordre de 350 à 1 000 microns, en particulier de 400 à 800 microns.

2. Charge particulaire selon la revendication 1, dans laquelle ledit revêtement métallique conducteur est composé d'un ou plusieurs métaux choisis dans le groupe constitué par le nickel, le cuivre, l'aluminium, l'étain, le cobalt, le zinc, l'or, l'argent, le platine, le palladium, le rhodium, l'indium, l'iridium et leurs alliages et le revêtement métallique composite est composé d'un revêtement en métal non noble choisi dans le groupe constitué par le nickel, le cuivre, l'aluminium, l'étain, le cobalt, l'indium et le zinc revêtant le noyau à base de carbone et un métal noble choisi dans le groupe constitué par l'or, l'argent, le platine, le palladium, le rhodium et l'iridium encapsulant le revêtement en métal non noble, et/ou le métal conducteur ou alliage de ceux-ci comprend 20 à 90 % en poids des particules revêtues, en particulier environ 40 à 90 % en poids.

3. Charge conductrice particulaire selon la revendication 1 ou 2, dans laquelle ledit revêtement métallique conducteur est en nickel et ledit noyau central à base de carbone est en graphite naturel ou en graphite synthétique, de préférence, le nickel représente 40 à 80 % en poids des particules revêtues et encapsule le noyau à base de carbone.

4. Charge conductrice particulaire selon l'une des revendications précédentes, dans laquelle ledit revêtement métallique composite comprend un revêtement de nickel du noyau à base de carbone et de l'or ou de l'argent encapsulant le revêtement de nickel.

5. Composition polymère conductrice comprenant une matrice polymère et une charge conductrice particulaire selon l'une des revendications 1 à 4 ci-dessus,
**caractérisée en ce que**
la charge conductrice particulaire comprend 25 à 35 % en volume de la composition polymère conductrice.

6. Composition polymère conductrice selon la revendication 5, dans laquelle la matrice polymère est choisie dans le groupe constitué par les caoutchoucs hydrocarbonés (EPM, EPDM, butyle et similaires), les nitriles, les poly(chloroprènes), l'acrylique, les poly(éthylènes) fluoro- et chlorosulfonés, les poly(uréthanes), les poly(éthers), les poly(sulfures), les caoutchoucs nitroso, les silicones et fluorosilicones, et/ou ledit métal conducteur est composé d'un ou plusieurs métaux choisis dans le groupe constitué par le nickel, le cuivre, l'aluminium, l'étain, le cobalt, le zinc, l'or, l'argent, le platine, le palladium, le rhodium, l'iridium l'indium et leurs alliages et/ou le métal conducteur ou alliage de celui-ci, de préférence, comprend 20 à 90 % en poids des particules revêtues, en particulier 40 à 90 % en poids.

7. Composition polymère conductrice selon la revendication 5 ou 6, dans laquelle le revêtement métallique conducteur est le nickel et ledit noyau central à base de carbone est en poudre de graphite naturel ou synthétique, ledit revêtement de nickel encapsulant le graphite naturel ou synthétique, et/ou ladite matrice polymère est de préférence un polymère de silicone et/ou de préférence, le nickel comprend 40 à 80 % en poids des particules revêtues et encapsule le noyau à base de carbone, ladite charge particulaire comprenant environ 30 % en volume de la composition polymère conductrice.

8. Composition polymère conductrice selon l'une quelconque des revendications 5 à 7, dans laquelle le revêtement métallique composite est composé d'un revêtement en métal non noble choisi dans le groupe constitué par le nickel, le cuivre, l'aluminium, l'étain, le cobalt, l'indium et le zinc revêtant le noyau à base de carbone et un métal noble choisi dans le groupe constitué par l'or, l'argent, le platine, le palladium, le rhodium et l'iridium encapsulant le revêtement en métal non noble, et/ou la poudre de graphite, de préférence, présente une taille moyenne d'environ 600 microns et le nickel comprend environ 60 % en poids des particules revêtues et/ou comprenant de préférence également 1 à 30 % en poids de charges conductrices particulaires matérialisées par des sphères en verre revêtues d'argent présentant une taille de l'ordre de 20 à 200 microns.

9. Procédé de production d'un bouclier électromagnétique pour une application à un substrat comprenant les étapes consistant à former un matériau composite d'une matrice polymère et une charge conductrice particulaire dispersée uniformément dans la matrice polymère, ladite charge particulaire comprenant un noyau central à base de carbone choisi dans le groupe constitué par le graphite naturel, le graphite synthétique, le noir de carbone et leurs mélanges, et un revêtement métallique conducteur ou un revêtement métallique composite encapsulant ledit noyau central à base de carbone,
**caractérisé en ce que**
le matériau composite comprend 25 à 35 % en volume de la charge conductrice particulaire, ladite matrice polymère étant choisie dans le groupe constitué par les caoutchoucs hydrocarbonés (EPM, EPDM, butyle et similaires), les nitriles, les poly(chloroprènes), l'acrylique, les poly(éthylènes) fluoro- et chlorosulfonés, les poly(uréthanes), les poly(éthers), les poly(sulfures), les caoutchoucs nitroso, les silicones et fluorosilicones, ledit revêtement métallique conducteur ou revêtement métallique composite comprenant un ou plusieurs métaux choisis dans le groupe constitué par le nickel, le cuivre, l'aluminium, l'étain, le cobalt, le zinc, l'or, l'argent, le platine, le palladium, le rhodium, l'iridium, l'indium et leurs alliages et le noyau à base de carbone ayant une taille moyenne de l'ordre de 350 à 1 000 microns, en particulier 400 à 800 microns.

10. Procédé selon la revendication 9, dans lequel le revêtement métallique, le revêtement métallique composite ou alliage de ceux-ci, comprend 20 à 90 % en poids des particules revêtues, de préférence environ 40 à 90 % en poids des particules revêtues et/ou, de préférence, le métal conducteur est le nickel et le noyau central à base de carbone est en graphite naturel ou en graphite synthétique, ayant une taille moyenne de particule d'environ 600 microns, ledit nickel étant constitué d'environ 60 % en poids des particules revêtues, et la charge conductrice comprend environ 30 % en volume du matériau composite, et/ou, de préférence, le revêtement métallique composite comprend un métal non noble choisi dans le groupe constitué par le nickel, le cuivre, l'aluminium, l'étain, le cobalt, l'indium et le zinc, de préférence le nickel, revêtant le noyau à base de carbone, et un métal noble choisi dans le groupe constitué par l'or, l'argent, le platine, le palladium, le rhodium, l'iridium et leurs alliages, de préférence l'or ou l'argent encapsulant le revêtement métallique non noble et/ou de préférence, le polymère est la silicone et le revêtement métallique composite comprend du nickel revêtant le noyau à base de carbone, et l'or ou l'argent encapsulant le revêtement en nickel et/ou de préférence, la charge particulaire comprend également 1 à 30 % en poids de charges conductrices particulaires matérialisées par des sphères en verre revêtues d'argent présentant une taille de l'ordre de 20 à 200 microns.
